# EUROPEAN PATENT APPLICATION

(11) **EP 4 524 413 A1**
(43) Date of publication of application: **19.03.2025**
(21) Application number: 24814125.1
(22) Date of filing: 08.05.2024
(51) Int. Cl.: F16C 11/04

(54) **FOLDING CONTROL MECHANISM HAVING STOP FUNCTION**

(30) Priority: 26.05.2023 CN 202310610526
(71) Applicant: Huawei Technologies Co., Ltd., Shenzhen, Guangdong 518129 (CN)
(72) Inventor: SHI, Tuo, Shenzhen, Guangdong 518129 (CN); ZHAN, Qiang, Shenzhen, Guangdong 518129 (CN); CHEN, Jiangbo, Shenzhen, Guangdong 518129 (CN)
(74) Representative: Maiwald GmbH
(86) International application number: PCT/CN2024/091553
(87) International publication number: WO 2024/244922

(57) **Abstract**

This application provides a folding control mechanism. The folding control mechanism includes a base and a first rotating assembly. The first rotating assembly includes a first swing arm and a first housing fastening bracket, the first swing arm is rotatably connected to the base, and the first swing arm is slidably connected to the first housing fastening bracket. The first housing fastening bracket is provided with a first sliding groove, the first sliding groove extends in a first direction or a second direction, and the first swing arm is installed in the first sliding groove and is capable of sliding in the first sliding groove in the first direction or the second direction. A first stop block is disposed between the first swing arm and the first housing fastening bracket. The first stop block is configured to prevent the first swing arm from being overfolded at a negative angle relative to the base, and therefore prevent impact on precision of an unfolding angle and user experience.

## Description

### TECHNICAL FIELD

This application relates to the field of terminal technologies, and specifically, to a folding control mechanism with a stop function.

### BACKGROUND

As flexible display technologies are gradually mature, display manners of electronic devices are driven to greatly change. A mobile phone with a foldable flexible display, a tablet computer with a foldable flexible display, a wearable electronic device with a foldable flexible display, and the like are an important evolution direction of intelligent electronic devices in the future.

A flexible display is a key component of a foldable electronic device, and has features of continuity and foldability. A folding control mechanism is used as an important component for implementing a folding function of the foldable electronic device. In a process of unfolding and folding the foldable electronic device, the folding control mechanism may drive the flexible display to be unfolded or folded.

For a foldable electronic device with a high use frequency, whether the electronic device can be accurately unfolded severely affects display effect of content on a screen and user experience. Therefore, how to control an angle and precision in an unfolded state is a problem that needs to be paid attention to and resolved currently.

### SUMMARY

This application provides an unfolded state control mechanism. The unfolded state control mechanism can effectively reduce relative movement between an arc arm and an installation plate by using a stop block, and can accurately control an angle in an unfolded state, to prevent overfolding or unevenness. In this way, user experience is effectively improved and product competitiveness is improved.

According to a first aspect, this application provides a folding control mechanism. The folding control mechanism may be used in a foldable electronic device, the folding control mechanism includes a base and a first rotating assembly, and the first rotating assembly is rotatably connected to the base. The first rotating assembly includes a first swing arm and a first housing fastening bracket, the first swing arm is rotatably connected to the base, and the first swing arm is slidably connected to the first housing fastening bracket. The first housing fastening bracket is provided with a first sliding groove, the first sliding groove extends in a first direction or a second direction, and the first swing arm is installed in the first sliding groove and is capable of sliding in the first sliding groove in the first direction or the second direction. The first direction is a direction in which the first housing fastening bracket moves toward the base, and the second direction is a direction in which the first housing fastening bracket moves away from the base. The folding control mechanism further includes a first stop block, and the first stop block is configured to stop a sliding track between the first swing arm and the first housing fastening bracket in a process of folding the folding control mechanism. The folding control mechanism precisely controls folded and unfolded states of the foldable electronic device by using the stop block, so that negative-angle folding does not occur, and user experience is effectively improved.

In a possible implementation, there is a first opening on the first swing arm, and the first stop block passes through the first opening and is in contact with a first stop surface to implement stop. The first opening is disposed to control the first stop block, to control an unfolding angle.

In a possible implementation, the first housing fastening bracket includes the first stop surface, and the first stop surface is used to limit an end of the first sliding groove. The first swing arm is fastened to the first stop block. The first swing arm moves in the first sliding groove in the second direction, and the first swing arm slides relative to the first housing fastening bracket until the first stop block is in contact with the first stop surface. Use of the first stop block can effectively control the folded state, and can also effectively control a folding angle through a design of the first stop block.

In a possible implementation, the first stop block has a protruding portion, and the protruding portion slides in the first sliding groove until the protruding portion is in contact with the first stop surface. The protruding portion is used to enable the first stop block to slide in the first sliding groove. One end of the first sliding groove is not blocked, and the other end is blocked by using a physical part on the first housing fastening bracket, so that a sliding distance of the first stop block in the first sliding groove is effectively controlled, to effectively control the unfolding angle.

In a possible implementation, the first stop block passes through the first opening and is fastened to the first swing arm in a welding manner. The first swing arm and the first stop block may be effectively fastened in a welding manner, so that the first swing arm and the first stop block are fastened to form a whole. The first swing arm is fastened together with the first stop block, to control a position of the first swing arm.

In a possible implementation, the first swing arm includes the first stop surface, and the first stop surface is located on an inner side of an end of the first opening. The first stop block is fastened to a physical part at an end of the first sliding groove on the first housing fastening bracket. The first swing arm moves in the first sliding groove in the second direction, the first swing arm slides relative to the first housing fastening bracket until the first stop block is in contact with the first stop surface, and the first stop surface is located on an inner side of an end that is of the first opening of the first swing arm and that is away from the base. Contact between the first stop surface and the first stop block can effectively perform stop and prevent the first housing fastening bracket from sliding relative to the first swing arm.

In a possible implementation, the first stop block is fastened to the first housing fastening bracket in a welding manner. In the welding manner, it can be ensured that the stop block and the first housing fastening bracket are fastened to form a whole.

In a possible implementation, the folding control mechanism further includes a second rotating assembly, and the second rotating assembly is rotatably connected to the base. The second rotating assembly includes a second swing arm and a second housing fastening bracket, the second swing arm is rotatably connected to the base, and the second swing arm is slidably connected to the second housing fastening bracket. The second housing fastening bracket is provided with a second sliding groove, the second sliding groove extends in a first direction or a second direction, and the second swing arm is installed in the second sliding groove and is capable of sliding in the second sliding groove in the first direction or the second direction. The first direction is a direction in which the second housing fastening bracket moves toward the base, and the second direction is a direction in which the first housing fastening bracket moves away from the base. The folding control mechanism further includes a second stop block, and the second stop block is configured to stop a sliding track between the second swing arm and the second housing fastening bracket in the process of folding the folding control mechanism. An implementation of this part is the same as an implementation of the first rotating assembly, and two parts of the folding control mechanism can be controlled to be unfolded at a same unfolding angle.

In a possible implementation, there is a second opening on the second swing arm, and the second stop block passes through the second opening and is in contact with a second stop surface to implement stop. Herein, a size of the second opening is controlled, so that a position and a size of the second stop block may be controlled.

In a possible implementation, the second housing fastening bracket includes the second stop surface, and the second stop surface is configured to limit an end of the second sliding groove. The second swing arm is fastened to the second stop block. The second swing arm moves in the second sliding groove in the second direction, and the second swing arm slides relative to the second housing fastening bracket until the second stop block is in contact with the second stop surface. The second stop block is in contact with the second stop surface, so that the second stop block stops sliding. In this way, the second swing arm fastened to the second stop block also stops sliding, and is connected to the second housing fastening bracket through the second stop block to form a whole.

In a possible implementation, the second stop block has a protruding portion, and the protruding portion slides in the second sliding groove until the protruding portion is in contact with the second stop surface. The protruding portion of the second stop block is in contact with an end of the second sliding groove, and the second stop block stops sliding and is connected to the first housing fastening bracket to form a whole.

In a possible implementation, the second stop block passes through the second opening and is fastened to the second swing arm in a welding manner. The welding manner may enable the second stop block and the second swing arm to form a whole, so that the second swing arm may be controlled in a stop manner of the second stop block.

In a possible implementation, the second swing arm includes the second stop surface, and the second stop surface is located on an inner side of an end of the second opening. The second stop block is fastened to a physical part at an end of the second sliding groove on the second housing fastening bracket. The second swing arm moves in the second sliding groove in the second direction, the second swing arm slides relative to the second housing fastening bracket until the second stop block is in contact with the second stop surface, and the second stop surface is located on an inner side of an end that is of the second opening of the second swing arm and that is away from the base. The second stop surface is in contact with the second stop block. In this case, the second stop block and the second housing fastening bracket form a whole, that is, the second swing arm is in contact with the second housing fastening bracket to form a whole.

In a possible implementation, the second stop block is fastened to the second housing fastening bracket in a welding manner. In the welding manner, the second stop block and the second housing fastening bracket can be connected to form a whole.

According to a second aspect, an electronic device is provided. The electronic device includes a folding control mechanism, a first housing, a second housing, a flexible display, and the foregoing folding control mechanism. The first housing and the second housing are respectively disposed on two opposite sides of the folding control mechanism. The first housing fastening bracket is fastened to the first housing, the first swing arm is slidably connected to the first housing fastening bracket, and the first stop block is disposed between the first housing fastening bracket and the first swing arm. The second housing fastening bracket is fastened to the second housing, the second swing arm is slidably connected to the second housing fastening bracket, and the second stop block is disposed between the second housing fastening bracket and the second swing arm. The flexible display contiguously covers the first housing, the second housing, and the folding control mechanism, and the flexible display is fastened to the first housing and the second housing. The electronic device fastens the first stop block in the first rotating assembly to the first swing arm or fastens the first stop block to the first housing fastening bracket, and fastens the second stop block in the second rotating assembly to the second swing arm or fastens the second stop block to the second housing fastening bracket, to control the folding control mechanism. In this way, an unfolding angle and precision of the folding control mechanism can be effectively improved through adjustment on a size of the stop block, thereby improving user experience.

### BRIEF DESCRIPTION OF DRAWINGS

FIG. 1a is a folding diagram of an outwardly foldable electronic device according to an embodiment of this application;
FIG. 1b is an unfolding diagram of an outwardly foldable electronic device according to an embodiment of this application;
FIG. 1c is a diagram of a structure of a folding control mechanism for controlling an outwardly foldable electronic device according to an embodiment of this application;
FIG. 2a is an exploded diagram of a folding control mechanism according to an embodiment of this application;
FIG. 2b is a diagram of a structure of a first combined swing arm in which a first swing arm 202 is fastened to a first stop block 203 according to an embodiment of this application;
FIG. 2c is a diagram of a three-dimensional structure in which a first combined swing arm is used in a folding control mechanism according to an embodiment of this application;
FIG. 2d is a cross-sectional diagram of a folded state in which a first combined swing arm is used in a folding control mechanism according to an embodiment of this application;
FIG. 2e is a cross-sectional diagram of an unfolded state in which a first combined swing arm is used in a folding control mechanism according to an embodiment of this application;
FIG. 3a is an exploded diagram of another folding control mechanism according to an embodiment of this application;
FIG. 3b is a diagram of a structure of a first combined housing fastening bracket in which a first housing fastening bracket 201 is fastened to a first stop block 203 according to an embodiment of this application;
FIG. 3c is a cross-sectional diagram of a three-dimensional structure in a folded state in which a first combined housing fastening bracket is used in a folding control mechanism according to an embodiment of this application; and
FIG. 3d is a cross-sectional diagram of a three-dimensional structure in an unfolded state in which a first combined housing fastening bracket is used in a folding control mechanism according to an embodiment of this application.

100: base; 200: first rotating assembly; 201: first swing arm; 202: first housing fastening bracket; 203: first stop block; 2011: first sliding groove; 2012: first stop surface;
300: second rotating assembly; 301: second swing arm; 302: second housing fastening bracket; 303: second stop block; 3011: second sliding groove; and 3012: second stop surface.

### DESCRIPTION OF EMBODIMENTS

The following describes embodiments of this application in detail. Examples of embodiments of this application are shown in accompanying drawings. In the accompanying drawings, same or similar reference numerals indicate same or similar elements or elements having a same or similar function. Embodiments described below with reference to the accompanying drawings are examples, and are merely used to explain this application, and shall not be understood as a limitation on this application.

Terms "first", "second", "third", "fourth", and the like (if exist) in this application are intended to distinguish between similar objects but do not necessarily indicate a specific order or sequence. It should be understood that data termed in such a way are interchangeable in proper circumstances.

A term "and/or" in embodiments of this application describes only an association relationship for describing associated objects and indicates that three relationships may exist. For example, A and/or B may indicate the following three cases: Only A exists, both A and B exist, and only B exists. In addition, a character "/" in this specification generally indicates an "or" relationship between the associated objects. In addition, "at least one of A, B, and C" indicates that (A), (B), (C), (A and B), (A and C), (B and C), or (A, B and C) may exist.

To make technical problems resolved, technical solutions used, and technical effect achieved in this application clearer, the following further describes the technical solutions in embodiments of this application in detail with reference to the accompanying drawings. It is clear that the described embodiments are merely some rather than all of embodiments of this application.

There is not too much research on unfolded state control for an electronic device with a flexible display in a current market, and most of research focuses on how to fold and unfold the flexible display. For an unfolding angle, user experience in an unfolded state, and the like, there are not a large quantity of research results in a current technical direction. Therefore, a folding control mechanism provided in this application is particularly important.

To improve angle precision in an unfolded state to further improve a specification of exquisiteness of a folding mechanism, optimize user experience, and improve overall product competitiveness, this application provides a folding control mechanism. Details are described in the following.

### Embodiment 1

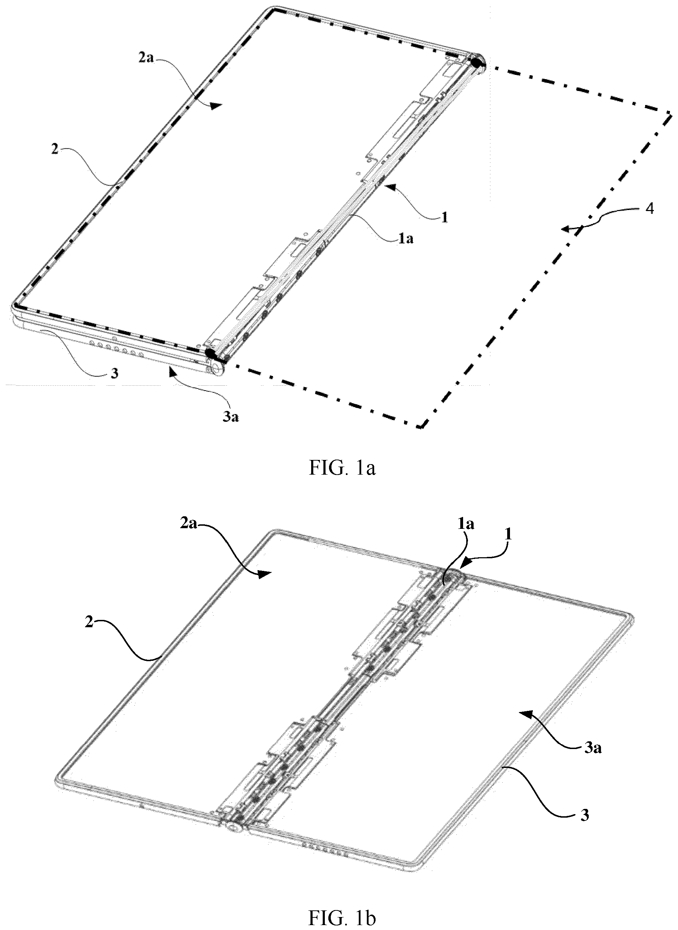

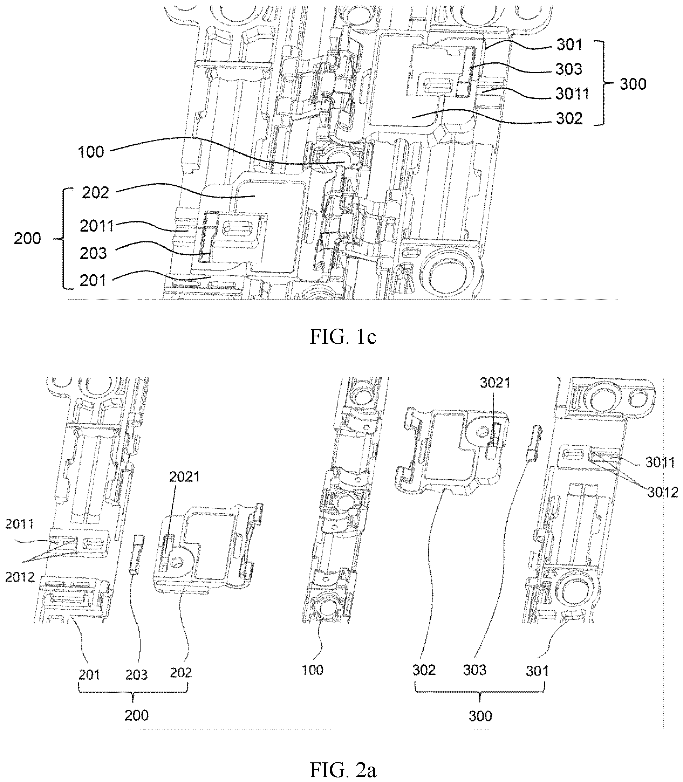

To facilitate understanding of a folding control mechanism provided in embodiments of this application, the following first describes an application scenario of the folding control mechanism. The folding control mechanism may be used in but is not limited to a foldable electronic device such as a mobile phone, a palmtop computer (personal digital assistant, PDA), a notebook computer, or a tablet computer. When the folding control mechanism provided in embodiments of this application is used in the electronic device, as shown in FIG. 1a, the electronic device includes a folding control mechanism 1, two housings, and a flexible display 4 (a dashed box shown in FIG. 1a). For ease of description, the two housings may be respectively named as a first housing 2 and a ground housing 3. The folding control mechanism includes a base, a first rotating assembly 200 (as shown in FIG. 1c), and a second rotating assembly 300 (as shown in FIG. 1c). In addition, the first housing 2 and the first housing 3 are located on two sides of the folding control mechanism 1, and can rotate around the folding control mechanism. During use, the electronic device may be folded and unfolded in different use scenarios.

In this application, the electronic device may be an outwardly foldable electronic device. In a process of switching the outwardly foldable electronic device from an unfolded state to a folded state, the flexible display 4 is always located on an outer side of the electronic device. FIG. 1a shows a relative position relationship between the folding control mechanism 1 and the two housings when the electronic device is in the folded state. In this case, a first surface of the folding control mechanism 1, a first surface of the first housing 2, and a first surface of the second housing 3 may be jointly used as a support surface of the flexible display 4. The flexible display 4 is omitted in FIG. 1. The first surface of the folding control mechanism 1 is a surface that is of the folding control mechanism 1 and that faces the flexible display 4, the first surface of the first housing 2 is a surface that is of the first housing 2 and that faces the flexible display 4, and the first surface of the second housing 3 is a surface that is of the second housing 3 and that faces the flexible display 4. For ease of description, in this application, the first surface of the folding control mechanism 1 may be defined as a bearing surface 1a of the folding control mechanism 1, the first surface of the first housing 2 may be defined as a first support surface 2a, and the first surface of the second housing 3 may be defined as a second support surface 3a.

Refer to FIG. 1b. FIG. 1b is a diagram of a structure of the electronic device in the unfolded state, and FIG. 1b shows structures of the first support surface 2a of the first housing 2 and the second support surface 3a of the second housing 3. In the unfolded state, the bearing surface 1a of the folding control mechanism 1, the first support surface 2a of the first housing 2, and the second support surface 3a of the second housing 3 may be connected to form a flat support surface.

Based on this, the flexible display 4 may contiguously cover the bearing surface 1a of the folding control mechanism 1, the first support surface 2a of the first housing 2, and the second support surface 3a of the second housing 2. The folding control mechanism 1 is disposed corresponding to a foldable part of the flexible display 4, and the flexible display 4 may be fastened to the first support surface 2a of the first housing 2 and the second support surface 3a of the second housing 3. A connection manner thereof may be but is not limited to bonding. In this way, when the electronic device is in the unfolded state shown in FIG. 1b, the folding control mechanism 1, the first housing 2, and the second housing 3 may flatly support the flexible display 4.

The application scenario and an application embodiment of the folding control mechanism are described above. To describe a structure of the folding control mechanism more clearly, the following describes a specific structure of the folding control mechanism in detail. FIG. 1c is a diagram of a rear structure of the first housing and the second housing. The structure is referred to as a folding control mechanism, and is mainly configured to control folding and unfolding of a foldable screen. FIG. 1c is a diagram of a structure of the folding control mechanism for controlling the outwardly foldable electronic device. FIG. 1c includes the base 100, the first rotating assembly 200, and the second rotating assembly 300. The first rotating assembly 200 includes a first housing fastening plate 201, a first swing arm 202, a first stop block 203, and a first sliding groove 2011. The first swing arm 202 is rotatably connected to the base 200, and the first housing fastening plate 201 is slidably connected to the first swing arm 202. The first housing fastening bracket 201 is provided with the first sliding groove 2011, the first sliding groove 2011 extends in a first direction or a second direction, and the first sliding groove 2011 is installed on the first swing arm 202 and is capable of sliding in the first sliding groove 2011 in the first direction or the second direction. The first direction indicates a direction in which the first housing fastening bracket 201 moves toward the base 100, and the second direction indicates a direction in which the first housing fastening bracket 201 moves away from the base 100. One end of the first sliding groove 2011 is not blocked by a physical object. The other end is blocked by a physical object, and may be configured to limit a distance of sliding along the first sliding groove 2011. The end with a physical obstacle belongs to a part of the first housing fastening bracket 201. The first stop block 203 may be fastened to the first swing arm 202, or may be fastened to the first housing fastening plate 201. The first stop block 203 is configured to stop a sliding track between the first swing arm 202 and the first housing fastening bracket in a process of folding the folding mechanism. A specific setting and a specific implementation process of the first stop block 203 are described in detail in the following embodiments. Details are not described herein again.

The second rotating assembly 300 includes a second housing fastening plate 301, a second swing arm 302, a second stop block 303, and a second sliding groove 3011. The second housing fastening plate 301 is rotatably connected to the base 100, and the second housing fastening plate 301 is slidably connected to the second swing arm 302. The second housing fastening bracket 301 is provided with the second sliding groove 3011, the second sliding groove 3011 extends in a first direction or a second direction, and the second sliding groove 3011 is installed on the second swing arm 302 and is capable of sliding in the second sliding groove 3011 in the first direction or the second direction. The first direction indicates a direction in which the second housing fastening bracket 301 moves toward the base 100, and the second direction indicates a direction in which the second housing fastening bracket 301 moves away from the base 100. One end of the second sliding groove 3011 is not blocked by a physical object. The other end is blocked by a physical object, and may be configured to limit a distance of sliding along the second sliding groove 3011. The end with a physical obstacle belongs to a part of the second housing fastening bracket 301. The second stop block 303 may be fastened to the second swing arm 302, or may be fastened to the second housing fastening plate 301. The second stop block 303 is configured to stop a sliding track between the second swing arm 302 and the second housing fastening bracket in the process of folding the folding mechanism. Two structures of the folding control mechanism are briefly described above. The first stop block 203 in the first rotating assembly 200 and the second stop block 303 in the second rotating assembly 300 are key components for accurately controlling folding and unfolding by the folding rotating mechanism. A structure of the folding control mechanism and a function of the stop block are separately described in detail in the following embodiments.

### Embodiment 2

Based on Embodiment 1, this embodiment discloses a folding control mechanism for stopping in a manner of fastening the first swing arm 202 to the first stop block 203 in FIG. 1c. FIG. 2a is an exploded diagram of a folding mechanism according to an embodiment of this application. In the figure, the folding mechanism includes: a base 100, a first rotating assembly 200, and a second rotating assembly 300. The first rotating assembly includes a first swing arm 202, a first opening 2021, a first housing fastening bracket 201, a first stop block 203, a first sliding groove 2011, and a first stop surface 2012. The second rotating assembly includes a second swing arm 302, a second opening 3021, a second housing fastening bracket 301, a second stop block 303, a second sliding groove 3011, and a second stop surface 3012. The first opening 2021 is located on the first swing arm 202, and the second opening 3021 is located on the second swing arm 302. The first rotating assembly 200 and the second rotating assembly 300 are completely same assemblies, and are distributed on two sides of the base 100. Herein, separately numbering the first rotating assembly 200 and the second rotating assembly 300 is based on a position relationship.

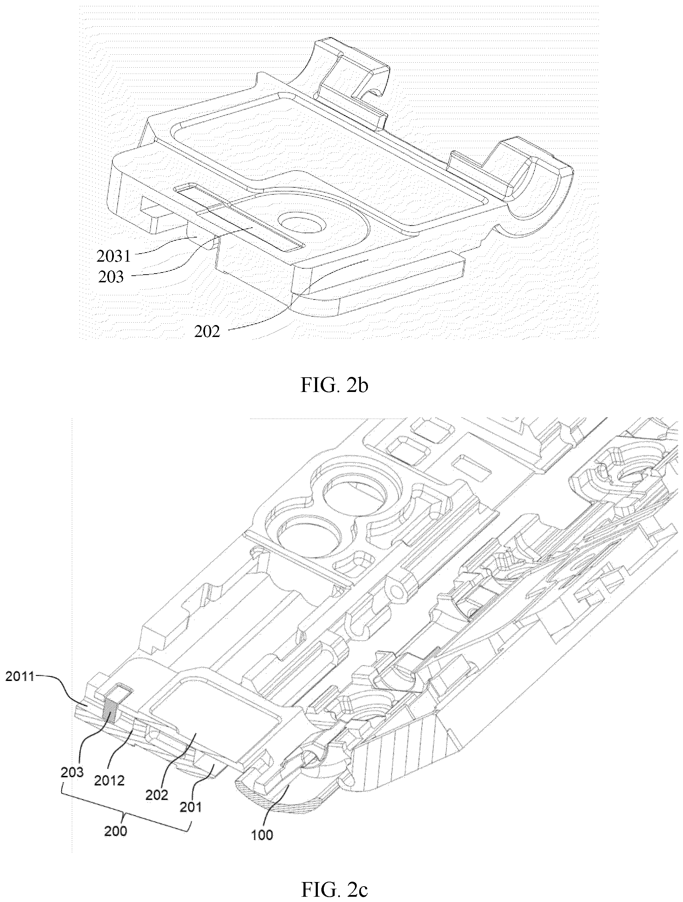

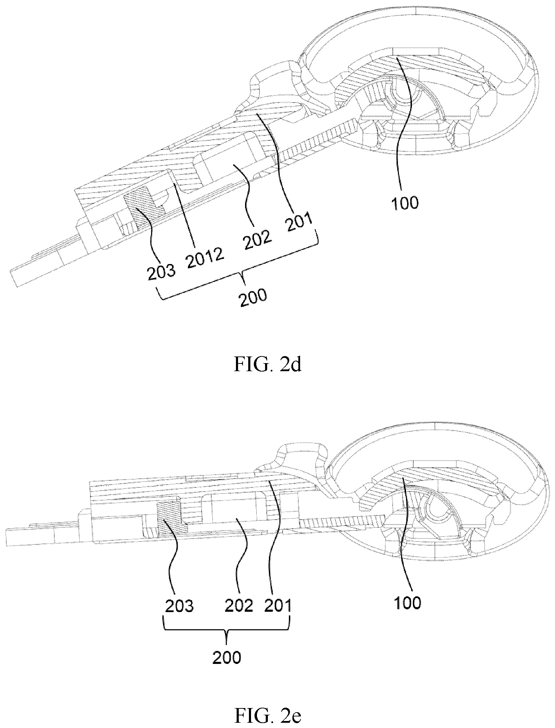

Architectures of the first rotating assembly and the second rotating assembly that are located on the two sides of the base are symmetrical, and functions of the assemblies are also consistent. Therefore, to simplify description, one side is used as an example for detailed description herein. This embodiment of this application mainly describes in detail a manner of fastening the first swing arm 202 to the first stop block 203 in FIG. 2a. As shown in FIG. 2b, FIG. 2b is a diagram of fastening the first swing arm 202 to the first stop block 203. The first stop block 203 has a protruding portion 2031, and the protruding portion 2031 slides in the first sliding groove 2011. In addition, there is one first opening in the first swing arm 202, the first stop block 203 passes through the first opening and is in contact with the first stop surface 2012, namely, an end that is of the first sliding groove 2011 and that has a physical part, to implement stop effect. One end of the first sliding groove 2011 is not blocked by a physical object. The other end is a physical part. The physical part is located on the first housing fastening bracket 201, is a part of the first housing fastening bracket 203, and is configured to prevent the first stop block from continuing to slide along the first sliding groove 2011. Therefore, a length of the first sliding groove 2011 is controlled, so that a sliding distance of the first stop block 203 in the first sliding groove 2011 may be controlled. The first stop block 203 is welded or hinged to the first swing arm 202 in a fastening manner to form a whole. FIG. 2c shows a diagram of a three-dimensional structure of the folding control mechanism more clearly. As shown in FIG. 2c, the first swing arm 202 is fastened to the first stop block 203. To distinguish, herein, the first swing arm 202 fastened to the first stop block 203 is referred to as a first combined swing arm. The first combined swing arm is rotatably connected to the base 100, and the first housing fastening bracket 201 is slidably connected to the first combined swing arm, so that the first housing fastening bracket 201 can rotate around the base 100. The first housing fastening bracket 201 is provided with the first sliding groove 2011, the first sliding groove 2011 extends in a first direction or a second direction, the first sliding groove 2011 is installed on the first combined swing arm, and the first combined swing arm may slide in the first sliding groove 2011 in the first direction or the second direction. The first direction indicates a direction in which the first housing fastening bracket 201 moves toward the base 100, and the second direction indicates a direction in which the first housing fastening bracket 201 moves away from the base 100. In a process in which the first housing fastening bracket 201 moves in the second direction, the first combined swing arm slides along the first sliding groove 2011, the first combined swing arm slides relative to the first housing fastening bracket 201, and there is no contact between the first stop block 203 and the first stop surface 2012 and there is a gap in the middle. FIG. 2d is a cross-sectional view of a folded state of the folding control mechanism. There is a gap between the first stop block 203 and the first stop surface 2012, the first combined swing arm continues to slide along the first sliding groove 2011 until the first stop block 203 is in contact with the first stop surface 2012, and the first combined swing arm and the first housing fastening bracket are clamped into a whole. FIG. 2e is a cross-sectional view of an unfolded state of the folding control mechanism. In this case, there is no gap between the first stop block 203 and the first stop surface 2012, to be specific, the first stop block 203 is in contact with the first stop surface 2012. In FIG. 2e, a part of the first stop surface 2012 overlaps a part of the first stop block 203. In addition, a whole including the first housing fastening bracket 201 and the first combined swing arm is in the unfolded state with the base 100.

### Embodiment 3

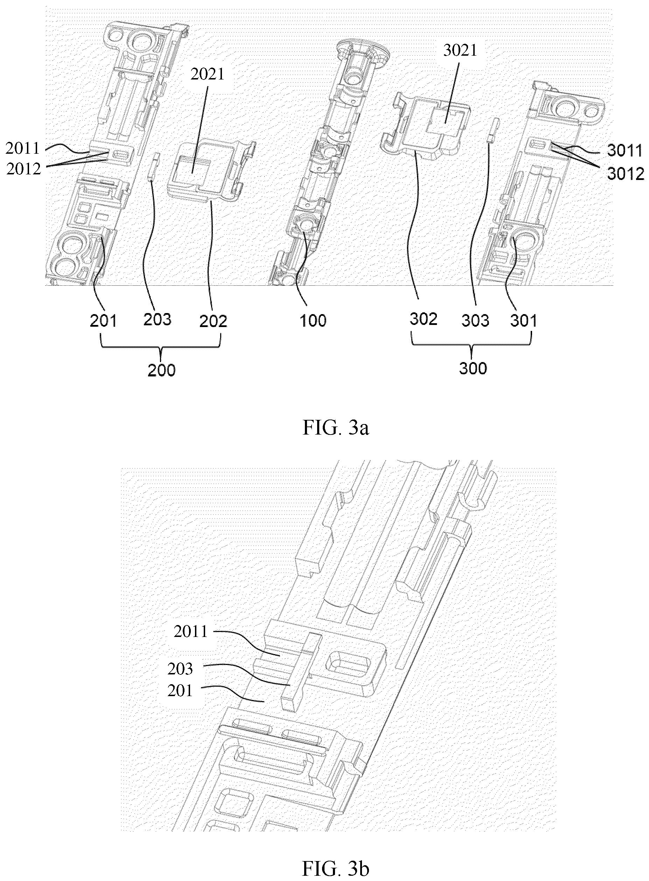

Based on the foregoing embodiments, this embodiment discloses a folding control mechanism that implements stop in a manner of fastening the first housing fastening bracket 201 to the first stop block 203 in FIG. 1c. FIG. 3a is an exploded diagram of another folding mechanism according to an embodiment of this application. In the figure, the folding mechanism includes: a base 100, a first rotating assembly 200, and a second rotating assembly 300. The first rotating assembly includes a first swing arm 202, a first opening 2021, a first housing fastening bracket 201, a first stop block 203, a first sliding groove 2011, and a first stop surface 2012. The second rotating assembly includes a second swing arm 302, a second opening 3021, a second housing fastening bracket 301, a second stop block 303, a second sliding groove 3011, and a second stop surface 3012. The first opening 2021 is located on the first swing arm 202, and the second opening 3021 is located on the second swing arm 302. The first rotating assembly 200 and the second rotating assembly 300 are completely same assemblies, and are distributed on two sides of the base 100. Herein, separately numbering the first rotating assembly 200 and the second rotating assembly 300 is based on a position relationship.

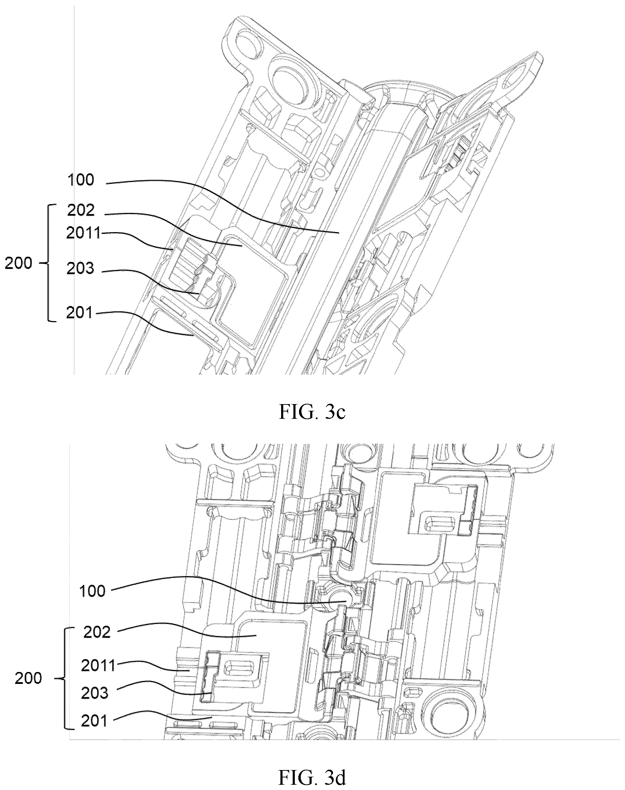

To simplify description, one side is used as an example for detailed description herein. This embodiment of this application mainly describes in detail a manner of fastening the first housing fastening bracket 201 to the first stop block 203 in FIG. 3a. As shown in FIG. 3b, FIG. 3b is a diagram of fastening the first housing fastening bracket 201 to the first stop block 203. The first stop block 203 includes a protruding portion 2031 (as shown in FIG. 2b), and the protruding portion 2031 (as shown in FIG. 2b) is in the first sliding groove 2011 and is fastened to an end that is of the first sliding groove 2011 and that has a physical part. The end that is of the first sliding groove 2011 and that has the physical part belongs to a part of the first housing fastening bracket 201, and the physical part is configured to fasten to the first stop block 203. The fixed connection may be welding or hinged connection. Herein, the first housing fastening bracket 201 fastened to the first stop block 203 is referred to as a first combined housing fastening bracket. It should be noted that the first combined housing fastening bracket may be assembled in the following manner: First, the first housing fastening bracket 201 is installed, and then the first swing arm 202 is installed on the first housing fastening bracket 201. The first swing arm 202 has the first opening 2021, and the first stop block 203 passes through the first opening 2021 and is fastened to the first housing fastening bracket 201. The fixed connection may be: fastening the first stop block 203 to an end of the first sliding groove 2011 on the first housing fastening bracket 201 through welding or hinged connection. FIG. 3c is a diagram of a three-dimensional structure in which the first combined housing fastening bracket is used in the folding control mechanism. The first swing arm 202 is rotatably connected to the base 100, and the first combined housing fastening bracket is slidably connected to the first swing arm 202, so that the first housing fastening bracket 201 can rotate around the base 100. The first combined housing fastening bracket is provided with the first sliding groove 2011, the first sliding groove 2011 extends in a first direction or a second direction, the first sliding groove 2011 is installed on the first swing arm 202, and the first swing arm 202 may move in the first sliding groove 2011 in the first direction or the second direction. The first direction indicates a direction in which the first combined housing fastening bracket moves toward the base 100, and the second direction indicates a direction in which the first combined housing fastening bracket moves away from the base 100. In a process in which the first combined housing fastening bracket moves in the second direction, the first swing arm 202 slides along the first sliding groove 2011, the first swing arm 202 slides relative to the first combined housing fastening bracket, and the first stop block 203 fastened to the first housing fastening bracket 201 passes through the first opening 2021 in the first swing arm 202, and moves in the first opening 2021 along with the first swing arm 202 in a direction close to the first stop surface 2012. The first stop surface 2012 is an inner side of an end of the first opening 2021 on the first swing arm 202. At the beginning, there is no contact between the first stop block 203 and the first stop surface 2012 and there is a gap in the middle, the first swing arm 202 continues to slide along the first sliding groove 2011 until the first stop block 203 is in contact with the first stop surface 2012, and the first swing arm 202 and the first combined housing fastening bracket are clamped into a whole. FIG. 3d is a three-dimensional diagram of an unfolded state of the folding control mechanism. In this case, the first stop block 203 is in contact with the first stop surface 2012, to be specific, the first stop surface 2012 overlaps a part of the first stop block 203. In addition, a whole including the first combined housing fastening bracket and the first swing arm 202 is in the unfolded state with the base 100.

### Embodiment 4

Based on the foregoing embodiments, an electronic device is provided. The electronic device includes (as shown in FIG. 1a and FIG. 1b) a first housing 2, a second housing 3, a flexible display 4, and the foregoing folding control mechanism. The first housing and the second housing are respectively disposed on two opposite sides of the folding control mechanism. The folding control mechanism shown in FIG. 1c is used as an example. A first rotating assembly 200 and a second rotating assembly 300 are symmetrical, a first housing fastening bracket 201 is fastened to the first housing 2, a first swing arm 202 is slidably connected to the first housing fastening bracket 201, and a first stop block 203 is disposed between the first housing fastening bracket 201 and the first swing arm 202. A second housing fastening bracket is fastened to the second housing, a second swing arm 302 is slidably connected to the second housing fastening bracket 301, and a second stop block 303 is disposed between the second housing fastening bracket 301 and the second swing arm 302. The flexible display 4 contiguously covers the first housing 2, the second housing 3, and the folding control mechanism, and the flexible display 4 is fastened to the first housing 2 and the second housing 3.

The first stop block 203 may be separately fastened to the first housing fastening bracket 201 and the first swing arm 202, as described in Embodiment 2 and Embodiment 3. Details are not described herein again.

The foregoing descriptions are merely specific implementations of this application, but are not intended to limit a protection scope of this application. Any variation or replacement readily figured out by a person skilled in the art within a technical scope disclosed in this application shall fall within the protection scope of this application. Therefore, the protection scope of this application shall be subject to a protection scope of the claims.

## Claims

1. A folding control mechanism, wherein the folding control mechanism comprises a base and a first rotating assembly, and the first rotating assembly is rotatably connected to the base;
the first rotating assembly comprises a first swing arm and a first housing fastening bracket, the first swing arm is rotatably connected to the base, and the first swing arm is slidably connected to the first housing fastening bracket;
the first housing fastening bracket is provided with a first sliding groove, the first sliding groove extends in a first direction or a second direction, the first swing arm is installed in the first sliding groove and is capable of sliding in the first sliding groove in the first direction or the second direction, the first direction is a direction in which the first housing fastening bracket moves toward the base, and the second direction is a direction in which the first housing fastening bracket moves away from the base; and
the folding control mechanism further comprises a first stop block, and the first stop block is configured to stop a sliding track between the first swing arm and the first housing fastening bracket in a process of folding the folding control mechanism.

2. The folding control mechanism according to claim 1, wherein there is a first opening on the first swing arm, and the first stop block passes through the first opening and is in contact with the first stop surface to implement stop.

3. The folding control mechanism according to claim 2, wherein
the first housing fastening bracket comprises the first stop surface, and the first stop surface is configured to limit an end of the first sliding groove;
the first swing arm is fastened to the first stop block; and
the first swing arm moves in the first sliding groove in the second direction, and the first swing arm slides relative to the first housing fastening bracket until the first stop block is in contact with the first stop surface.

4. The folding control mechanism according to claim 3, wherein the first stop block has a protruding portion, and the protruding portion slides in the first sliding groove until the protruding portion is in contact with the first stop surface.

5. The folding control mechanism according to claim 3, wherein the first stop block passes through the first opening and is fastened to the first swing arm in a welding manner.

6. The folding control mechanism according to claim 2, wherein
the first swing arm comprises the first stop surface, and the first stop surface is located on an inner side of an end of the first opening;
the first stop block is fastened to a physical part at an end of the first sliding groove on the first housing fastening bracket; and
the first swing arm moves in the first sliding groove in the second direction, the first swing arm slides relative to the first housing fastening bracket until the first stop block is in contact with the first stop surface, and the first stop surface is located on an inner side of an end that is of the first opening of the first swing arm and that is away from the base.

7. The folding control mechanism according to claim 6, wherein the first stop block is fastened to the first housing fastening bracket in a welding manner.

8. The folding control mechanism according to claim 7, wherein
the folding control mechanism further comprises a second rotating assembly, and the second rotating assembly is rotatably connected to the base;
the second rotating assembly comprises a second swing arm and a second housing fastening bracket, the second swing arm is rotatably connected to the base, and the second swing arm is slidably connected to the second housing fastening bracket;
the second housing fastening bracket is provided with a second sliding groove, the second sliding groove extends in a first direction or a second direction, the second swing arm is installed in the second sliding groove and is capable of sliding in the second sliding groove in the first direction or the second direction, the first direction is a direction in which the second housing fastening bracket moves toward the base, and the second direction is a direction in which the first housing fastening bracket moves away from the base; and
the folding control mechanism further comprises a second stop block, and the second stop block is configured to stop a sliding track between the second swing arm and the second housing fastening bracket in the process of folding the folding control mechanism.

9. The folding control mechanism according to claim 8, wherein there is a second opening on the second swing arm, and the second stop block passes through the second opening and is in contact with the second stop surface to implement stop.

10. The folding control mechanism according to claim 9, wherein
the second housing fastening bracket comprises the second stop surface, and the second stop surface is configured to limit an end of the second sliding groove;
the second swing arm is fastened to the second stop block; and
the second swing arm moves in the second sliding groove in the second direction, and the second swing arm slides relative to the second housing fastening bracket until the second stop block is in contact with the second stop surface.

11. The folding control mechanism according to claim 10, wherein the second stop block has a protruding portion, and the protruding portion slides in the second sliding groove until the protruding portion is in contact with the second stop surface.

12. The folding control mechanism according to claim 10, wherein the second stop block passes through the second opening and is fastened to the second swing arm in a welding manner.

13. The folding control mechanism according to claim 9, wherein
the second swing arm comprises the second stop surface, and the second stop surface is located on an inner side of an end of the second opening;
the second stop block is fastened to a physical part at an end of the second sliding groove on the second housing fastening bracket; and
the second swing arm moves in the second sliding groove in the second direction, the second swing arm slides relative to the second housing fastening bracket until the second stop block is in contact with the second stop surface, and the second stop surface is located on an inner side of an end that is of the second opening of the second swing arm and that is away from the base.

14. The folding control mechanism according to claim 13, wherein the second stop block is fastened to the second housing fastening bracket in a welding manner.

15. An electronic device, comprising a folding control mechanism, a first housing, a second housing, a flexible display, and the folding control mechanism according to any one of claims 1 to 14, wherein
the first housing and the second housing are respectively disposed on two opposite sides of the folding control mechanism;
the first housing fastening bracket is fastened to the first housing, the first swing arm is slidably connected to the first housing fastening bracket, and the first stop block is disposed between the first housing fastening bracket and the first swing arm;
the second housing fastening bracket is fastened to the second housing, the second swing arm is slidably connected to the second housing fastening bracket, and the second stop block is disposed between the second housing fastening bracket and the second swing arm; and
the flexible display contiguously covers the first housing, the second housing, and the folding control mechanism, and the flexible display is fastened to the first housing and the second housing.
